# EUROPEAN PATENT SPECIFICATION

(11) **EP 0 539 161 B1**
(45) Date of publication and mention of the grant of the patent: **09.07.1997**
(21) Application number: 92309576.4
(22) Date of filing: 20.10.1992
(51) Int. Cl.: H01S 3/19

(54) **Semiconductor laser device**
Halbleiterlaservorrichtung
Dispositif laser à semi-conducteur

(30) Priority: 23.10.1991 JP 275706/91; 27.03.1992 JP 71731/92
(43) Date of publication of application: 28.04.1993
(73) Proprietor: KABUSHIKI KAISHA TOSHIBA, Kawasaki-shi, Kanagawa-ken 210 (JP)
(72) Inventor: Rennie, John, c/o Intellectual Property Division, Minato-ku, Tokyo 105 (JP); Okajima, Masaki c/o Intellectual Property Div., Minato-ku, Tokyo 105, (JP); Hatakoshi, Genichi c/o Intellectual Property Div., Minato-ku, Tokyo 105, (JP)
(74) Representative: Waldren, Robin Michael

(56) References cited:
- IEEE JOURNAL OF QUANTUM ELECTRONICS. vol. 27, no. 6, June 1991, NEW YORK US pages 1511 - 1519 T. TAKESHI ET AL 'Design and photoluminescence study on a multiquantum barrier'
- ELECTRONICS LETTERS. vol. 27, no. 12, 6 June 1991, STEVENAGE, HERTS, GB pages 1081 - 1082 T. TAKAGI ET AL 'Modified multiquantum barrier for 600 nm range AlGaInP lasers.'
- JAPANESE JOURNAL OF APPLIED PHYSICS, SUPPLEMENTS. EXTENDED ABSTRACTS OF THE 1991 INTERNATIONAL CONFERENCE ON SOLID STATE DEVICES AND MATERIALS 1991, YOKOHAMA JP pages 83 - 85 T. TAKESHI ET AL 'electron wave reflection by multiquantum barrier (MQB)'
- APPLIED PHYSICS LETTERS. vol. 58, no. 17, 29 April 1991, NEW YORK US pages 1822 - 1824 K. KISHINO ET AL 'Enhanced carrier confinement effect by the multiquantum barrier in 660 nm GaInP/AlInP visible lasers'
- ELECTRONICS LETTERS. vol. 22, no. 19, 11 September 1986, STEVENAGE, HERTS, GB pages 1008 - 1010 K. IGA ET AL 'Electron reflectance of multiquantum barrier (MQB)'

## Description

The present invention relates to a semiconductor laser device and, more particularly, to a semiconductor laser device with a multiquantum barrier.

Recently, semiconductor laser devices with a double hetero-(DH) structure capable of emitting red light having a wavelength of about 650 to 670 nm at a high efficiency have been developed. Semiconductor laser devices of this type have advantages such as a low threshold current density, a high maximum operating temperature, and a long operating life.

If, however, the DH structure is applied to a semiconductor laser device having an oscillation wavelength of less than 650 nm, problems such as a high threshold current density and a low maximum operating temperature arise. Short-wavelength laser devices are required to realize high-density recording in optical memories and are also expected to be used as light sources of bar-code readers. A semiconductor laser device with the DH structure is expected to be used as a light source of a bar-code reader because standard bar-code readers currently being used employ a helium-neon gas laser for emitting laser light having a wavelength of about 630 nm, and the use of a semiconductor laser device enables miniaturization of the light source.

It is assumed that the increase in threshold current density or the decrease in maximum operating temperature caused at short wavelengths of less than 650 nm in the semiconductor laser devices with the DH structure currently used are due to the following reason.

That is, as the oscillation wavelength is shortened, the height of a hetero barrier on the conduction band side between the active layer and the p-type cladding layer is decreased, and this allows carriers to flow from the active layer into the p-type cladding layer, thereby increasing the carrier loss.

To solve this problem, methods of forming a multiquantum barrier (MQB) between the active layer and the cladding layer have been proposed (Kishino et. al., Appl. Phys. Lett. 58 1991, p. 1822; Iga et. al., Electron Lett., 22 1986, p. 1008, IEEE Journal of Quantum Electronics, Vol. 27, No. 6, June 1991, pages 1511-1519).

Laser devices having the MQB structure (MQB semiconductor laser devices), however, have the following problem.

That is, the MQB structure involves a large number of parameters, such as a quantum well width and a barrier width, and these parameters are mutually associated with each other. Therefore, it is difficult to set all these parameters optimally, and this makes it difficult to fabricate a highly practical MQB semiconductor laser device.

As described above, since a large number of parameters are related to the laser characteristics of conventional MQB semiconductor laser devices, these devices are difficult to design and therefore poor in practicability.

The present invention has been made in consideration of the above situation and has as its object to provide a practical MQB semiconductor laser device.

According to the present invention, there is provided a semiconductor laser device comprising:
a substrate;
a first cladding layer formed on said substrate;
an active layer formed on said first cladding layer; and
a second cladding layer formed on said active layer having a conductivity type different from that of said first cladding layer,
wherein at least one of said first and second cladding layers has a multiquantum barrier structure including a plurality of barrier layers and a plurality of well layers, each barrier layer and each well layer being alternately stacked, the width of a first barrier layer relative to a side of said active layer being 24 to 100 nm and the width of a second barrier layer relative to a side of said active layer being 5 to 20 nm.

In addition, according to the present invention, there is provided a semiconductor laser device comprising:
a substrate;
a first cladding layer formed on said substrate;
an active layer formed on said first cladding layer; and
a second cladding layer formed on said active layer having a conductivity type different from said first cladding layer,
wherein at least one of said first and second cladding layers has a multiquantum barrier structure, and said multiquantum barrier structure is constituted by alternately stacking a plurality of barrier layers each consisting essentially of In_{Z}(Ga₁₋ₓAℓₓ)_{1-z}P, x is 0.7 to 1.0 and z is 0 to 1.0, and a plurality of well layers each consisting essentially of In_{z}(Ga_{1-y}Aℓ_{y})_{1-z}P, y is 0 to 0.3 and z is 0 to 1.0, the width of a first barrier layer relative to a side of said active layer being 24 to 100 nm, the width of a second barrier layer relative to a side of said active layer being 5 to 20 nm.

This invention can be more fully understood from the following detailed description when taken in conjunction with the accompanying drawings, in which:
Fig. 1 is a sectional view showing the main part of a semiconductor laser having an MQB structure according to one embodiment of the present invention;
Fig. 2 is a view showing the potential distribution of the MQB structure of the semiconductor laser shown in Fig. 1;
Fig. 3 is a graph showing the relationship between the electron reflectivity of the MQB and the relative electron energy;
Fig. 4 is a graph showing the relationship between the temperature and the relative threshold current density;
Fig. 5 is a graph showing the relationship between the quantum well width and the effective barrier height;
Fig. 6 is a graph showing the relationship between the width of the first quantum barrier and the effective barrier height;
Fig. 7 is a graph showing the relationship between the quantum barrier width and the effective barrier height;
Fig. 8 is a sectional view showing the main part of an MQB laser according to another embodiment of the present invention; and
Fig. 9 is a view showing the conduction band distribution of the MQB semiconductor laser shown in Fig. 8.

A semiconductor laser device according to the present invention comprises a substrate, a first cladding layer formed on the substrate, an active layer formed on the first cladding layer, and a second cladding layer formed on the active layer and having a conductivity type different from that of the first cladding layer. At least one of the first and second cladding layers has a multiquantum barrier structure. In a semiconductor laser device according to the first aspect of the present invention, the width of the first quantum barrier of the multiquantum barrier structure from the active layer side is 24 to 100 nm. If the width of the first quantum barrier is less than 24 nm, effects of classical barrier is insufficient and substantial height of the quantum barrier becomes low; if it exceeds 100 nm, the place where the classical barrier effect is caused is a long way from the place where the multiquantum barrier effect is caused, too much, and it is undesirable. In this case, the width of the second quantum barrier from the active layer side can be 5 to 20 nm.

If the width of the second quantum barrier is less than 5 nm, a gap of low reflectivity is generated between the classical barrier and the multiquantum barrier; if it exceeds 20 nm, the first quantum well is insufficiently coupled with the second quantum barrier.

In a semiconductor laser device according to the second aspect of the present invention, the multiquantum barrier structure is constituted by alternately stacking first thin layers consisting of In_{z}(Ga₁₋ₓAℓₓ)_{1-z}P, x is 0.7 to 1.0 and z is 0 to 1.0, and second thin layers consisting of In_{z}(Ga_{1-y}Aℓ_{y})_{1-z}P, y is 0 to 0.3 and z is 0 to 1.0. In this case, the width of the first quantum barrier from the active layer side can be 24 to 100 nm. The width of the second quantum barrier from the active layer side can be 5 to 20 nm.

In the semiconductor laser of each of the above aspects, it is preferable to set the other parameters as follows.
1. The widths of the third and subsequent quantum barriers of the multiquantum barrier structure from the active layer side are set to 1 to 8 nm.
2. The quantum well width of the multiquantum barrier structure is set to 1 to 8 nm.
3. At least one cladding layer has a multiquantum barrier structure consisting of Group II elements and Group VI elements.
4. The number of quantum barriers in the multiquantum barrier structure is set to 3 to 10.
5. As the material of the quantum wells of the multiquantum barrier structure, ZnSeₓTe₁₋ₓ, ZnCdₓSe, ZnSₓTe₁₋ₓ, Zn₁₋ₓCdₓS, or their alloy Zn₁₋ₓCdₓSe_{1-y-z}S_{y}Te_{z} is used. Alternatively, In₁₋ₓGaₓAs_{1-y}P_{y}, Ga₁₋ₓAℓₓAs, or In_{z}(Ga₁₋ₓAℓₓ)_{1-z}P is used. In these formulas, x and y are determined so as to satisfy inqualities 0 < x < 1, and 0 < y < 1.
6. As the material of the quantum barriers of the multiquantum barrier structure, ZnSySe_{1-y} or ZnₓMg₁₋ₓSe_{1-y} is used. In these formulas, x and y are determined so as to satisfy inqualities 0 < x < 1, and 0 < y < 1.

According to the studies of the present inventors, it is found that when In_{z}(Ga₁₋ₓAℓₓ)_{1-z}P (0 ≤ z ≤ 0.5) is used as the material of the cladding layers, the laser characteristics, such as the threshold current density and the laser gain, largely depend on a composition ratio (barrier layer composition ratio) x of In_{z}(Ga₁₋ₓAℓₓ)_{1-z}P constituting the quantum barriers, the number of quantum barriers, the quantum barrier width, the quantum well width, and a composition ratio (well layer composition ratio) y of In_{z}(Ga_{1-y}Aℓ_{y})_{1-z}P constituting the quantum wells.

When, therefore, attention is focused on these parameters, there is almost no necessity for taking into account the other parameters, and this makes highly efficient design feasible.

Embodiments of the present invention will be described below with reference to the accompanying drawings.

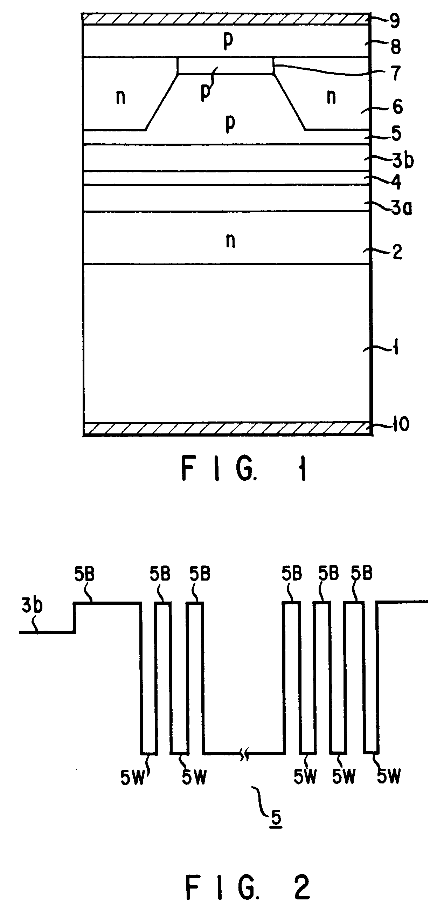

Fig. 1 is a sectional view showing the main part of an MQB semiconductor laser according to one embodiment of the present invention. Referring to Fig. 1, an n-type cladding layer 2 consisting of n-type In_{0.5}(Ga₁₋ₓAℓₓ)_{0.5}P and having a thickness of about 0.8 µm is formed on a GaAs substrate 1. An active layer 4 sandwiched between optical guide layers 3a and 3b consisting of undoped In_{0.5}(Ga_{1-y}Aℓ_{y})_{0.5}P is formed on the n-type cladding layer 2.

A p-type cladding layer 5 having an MQB structure consisting of p-type In_{0.5}(Ga₁₋ₓAℓₓ)_{0.5}P and having a thickness of about 0.8 µm is formed on the optical guide layer 3b, and the central portion of the layer 5 is formed into a mesa shape. The p-type cladding layer 5 having this shape can be formed by using conventional etching techniques. The p-type cladding layer 5 is formed into the mesa shape in order to increase the current density in the active region upon application of a current and to perform transverse mode control by producing a refractive index difference in the transverse direction. The p-type cladding layer 5, together with the n-type cladding layer 2, the optical guide layers 3a and 3b, and the active layer 4, constitutes a DH junction portion.

A p-type capping layer 7 consisting of p-type InGaP is formed on the mesa portion of the p-type cladding layer 5. The peripheral portions of the p-type cladding layer 5 and the p-type capping layer 7 are covered with an n-type current blocking layer 6 consisting of n-type GaAs. An Au/Zn p-type electrode 9 is formed on the n-type current blocking layer 6 and the p-type capping layer 7 via a p-type contact layer 8 consisting of p-type GaAs. An Au/Ge n-type electrode 10 is formed on the other side of the substrate 1.

Note, in the embodiment shown in Fig. 1, that an Aℓ composition ratio x of the cladding layers 2 and 5 is 0.7. The active layer 4 may be any light-emitting layer and may have a uniform structure like a double heterostructure or a structure subjected to energy modulation, such as an MQW structure.

Fig. 2 is a band diagram showing the potential distribution of the p-type cladding layer 5 having the MQB structure. Fig. 2 reveals that the energy level of the p-type cladding layer 5 is modulated. That is, the p-type cladding layer 5 has a structure in which two types of thin layers, i.e., In_{0.5}Ga_{0.5}P film and In_{0.5}(Ga_{0.3}Aℓ_{0.7})_{0.5}P film, having different compositions are alternately stacked to periodically form quantum wells 5W and quantum barriers 5B.

In this embodiment, to improve the laser characteristics, such as the threshold current and the maximum operating temperature, various parameters are optimized by focusing attention on the reflectivity of electrons. This optimization is performed by increasing the reflectivity for electrons in the multiquantum barrier structure.

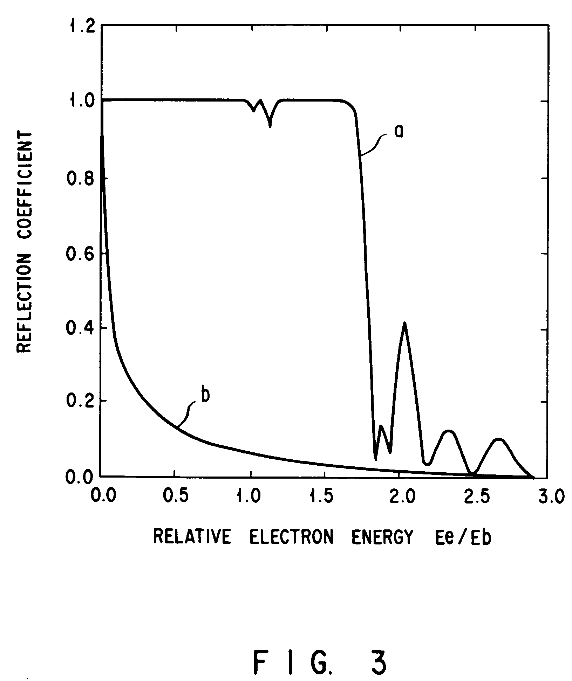

Fig. 3 is a graph showing the reflectivity of electrons as a function of the relative electron energy. Referring to Fig. 3, a curve b represents the characteristic of the classical barrier, i.e., the characteristic based on the assumption, as derived from the classical physics, that electrons having an energy smaller than the height of a hetero barrier are reflected. A curve a represents the characteristic of a quantum barrier, i.e., the characteristic obtained when the cladding layer has the MQB structure. In this MQB structure, the first barrier has an optimum thickness of 30 nm and the second barrier has an optimum thickness of 8 nm. Fig. 3 reveals that in the case of the classical barrier, if the energy of electrons exceeds the height of the hetero barrier, the reflectivity abruptly decreases. In the case of the MQB structure, on the other hand, a reflectivity of 1.0 is maintained even if the electron energy exceeds the height of the hetero barrier.

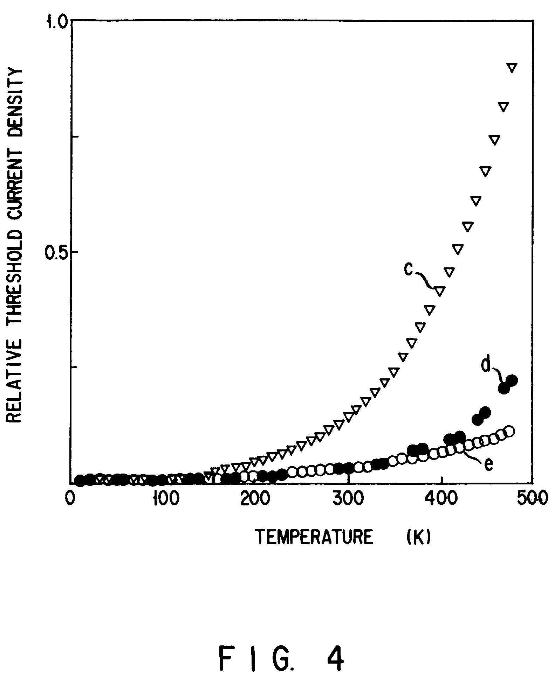

Fig. 4 is a graph showing the relationship between the temperature and the relative threshold current density. In Fig. 4, a curve c represents the characteristic obtained when the MQB structure is not adopted in the p-type cladding layer, and a curve d represents that obtained when the MQB structure is adopted in the p-type cladding layer. A curve e represents the characteristic of an ideal laser free from overflow of carriers from the active layer to the p-type cladding layer. As is apparent from Fig. 4, the relative threshold current can be improved by using the MQB structure in the p-type cladding layer, and this realizes the characteristic close to the ideal laser characteristic indicated by the curve e. This effect stems from the fact that the MQB structure in the p-type cladding layer maintains the reflectivity at 1.0 even if the electron energy exceeds the height of the hetero barrier.

In this embodiment, various parameters are set as follows in consideration of the above findings.

The reflectivity is affected by the barrier composition ratio x of In_{0.5}(Ga₁₋ₓAℓₓ)_{0.5}P constituting the quantum barriers of the p-type cladding layer 5 and the well layer composition ratio y of In_{0.5}(Ga_{1-y}Aℓ_{y})_{0.5}P constituting the quantum wells of the p-type cladding layer 5. That is, as the band gap difference (offset) between the quantum barrier and the quantum well is increased, the reflectivity with respect to electrons with a high energy is increased. In general, therefore, the effect is enhanced as the barrier layer composition ratio x is increased.

If, however, the barrier layer composition ratio x exceeds 0.7, In_{0.5}(Ga₁₋ₓAℓₓ)_{0.5}P changes from a direct transition type to an indirect transition type, and this introduces problems such as an increase in effective mass. For this reason, a high barrier layer composition ratio x does not always lead to a good result. It is found, however, that a good result can be obtained by the barrier layer composition ratio x within the range of 0.7 to 1.0 in accordance with the relationship with the value of the quantum well layer composition ratio.

It is desirable, on the other hand, that the well layer composition ratio y be 0 in order to maximize the offset. However, if the composition ratio of the active layer is higher than the well layer composition ratio y and the quantum well width is also large, laser oscillation may occur in a small well layer. When this influence of the active layer is taken into account, an optimal well layer composition ratio y depends on the composition ratio of the active layer, and it is generally 0 to 0.3.

In place of In_{0.5}(Ga₁₋ₓAℓ)_{0.5}P, another semiconductor material which allows lattice matching can be used as the material of the quantum well layer. The effect of the MQB described above is enhanced as the band gap of the well layer becomes small compared to that of the barrier layer and the effective mass decreases. Examples of such a well layer material are GaAs, GaAℓAs, and InGaAs.

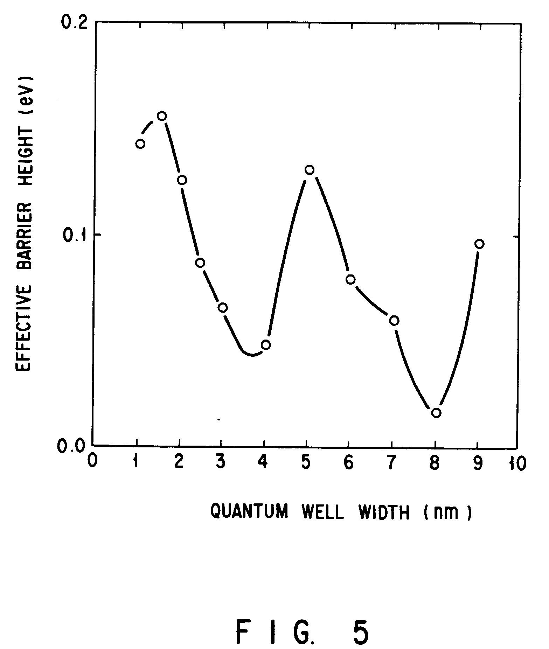

Fig. 5 is a graph showing the relationship between the quantum well width and the effective barrier height when the number of barriers is ten. It is obvious from Fig. 5 that the effective barrier height generally increases as the quantum well width decreases. This is so because when the quantum well width decreases, the interference effect is enhanced even for electrons with a high energy, and this increases the reflectivity. With this improvement in effective barrier height, overflow of carriers becomes hard to occur, and the characteristics such as the threshold current density are improved. Note that the effective barrier height decreases when the quantum well width is about 1.5 nm or less because the energy level of the quantum well nearly equals the energy height of the quantum barrier. Note also that though a smaller quantum well width is generally more preferable as described above, it is difficult to decrease the quantum well width to 0.3 nm or less using present film forming techniques.

When the quantum well width is large, on the other hand, almost no interference effect with respect to a high-energy electron wave can be obtained. In addition, if the quantum well width is large, problems such as emission recombination in a quantum well occur to degrade the laser characteristics.

When, therefore, these conditions are taken into consideration, the optimal quantum well width can be selected to be 1.0 to 8 nm.

Note that the quantum well width can be controlled by the quantum well depth. That is, when the quantum well depth increases, the quantum barrier height also increases. Therefore, the quantum well width can be increased by an amount corresponding to an increase in the quantum well depth. Note that the range of control by the quantum well depth is limited by the material used.

If the quantum barrier width is too small, the transmission coefficient of the wave function of electrons increases, so the quantum barrier cannot function as a barrier any longer. If, on the other hand, the quantum barrier width is too large, the interference effect between the quantum wells decreases, and this makes it impossible to obtain a satisfactorily large effective barrier height. In addition, since neighboring quantum barriers affect each other, it is necessary to determine an optimal width for each quantum barrier.

That is, the first quantum barrier from the active layer 4 side must be a classical barrier determined by the quantum tunneling width limit respect to electrons. For this reason, the quantum barrier width must be 24 nm or more. In addition, the quantum barrier width must be 100 nm or less for the reason described below.

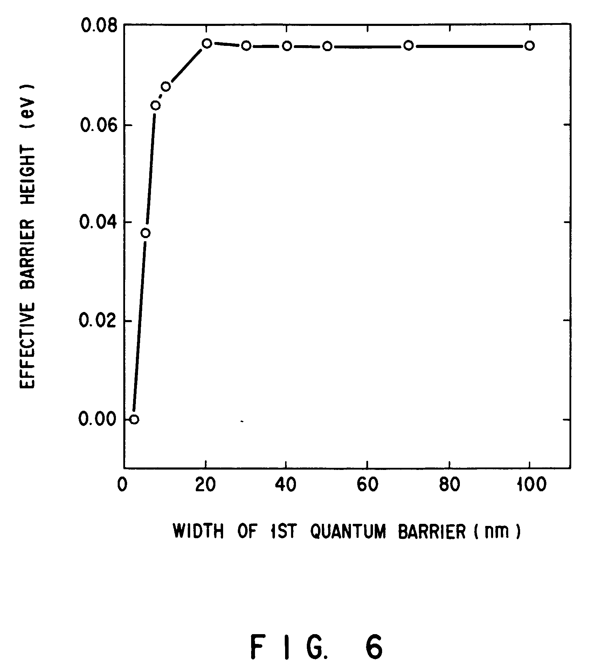

Fig. 6 is a graph showing the relationship between the width of the first quantum barrier from the active layer side and the effective barrier height when the number of quantum barriers is ten. As is apparent from Fig. 6, in general, when the width of the first quantum barrier increases, the effective barrier height also increases.

It is assumed that this effect is obtained since the first quantum barrier plays a role as the classical barrier represented by the curve b shown in Fig. 3. That is, the first quantum barrier must be a classical barrier determined by the quantum tunneling width limit respect to electrons. If the first quantum barrier width is too small, no satisfactory effect as a classical barrier can be obtained, resulting in a decrease in effective quantum barrier height. If, on the other hand, the first quantum barrier width is 24 nm or more, the effective quantum barrier height saturates. However, if the first barrier width is more than 100 nm, the location where the classical barrier effect occurs and the location where the multibarrier effect occurs are spatially separated too far from each other. As a result, the synergistic effect of them both is undesirably lost.

When these conditions are taken into account, therefore, the first quantum barrier width is preferably 24 to 100 nm, more preferably 24 to 60 if the number of quantum barriers is ten.

To assist the function as a barrier of the first quantum barrier, the second quantum barrier from the active layer 4 side must have a considerable thickness compared to the subsequent quantum barriers. According to the study of the present inventors, it is found that an optimal range is 1 to 20 nm. Note that the lower limit is determined in consideration of film forming techniques.

The widths of the third and subsequent quantum barriers from the active layer 4 side will be described below.

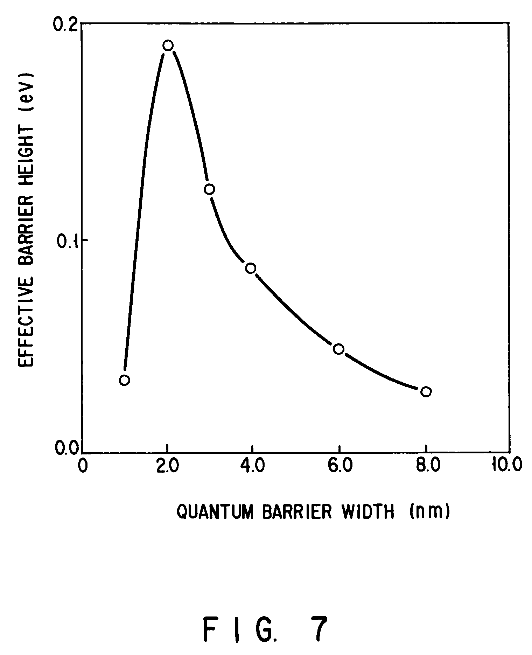

Fig. 7 is a graph showing the relationship between the quantum barrier width and the effective barrier height induced by the MQB effect when the number of quantum barriers is ten. Fig. 7 reveals that the effective barrier height is obtained from a quantum barrier width of 8.0 nm, increases as the quantum barrier width decreases, becomes largest when the quantum barrier width is about 2.0 nm, and decreases thereafter. Therefore, to obtain the MQB effect, the quantum barrier widths of the third and subsequent barriers may be set from 1 to 8 nm.

As described above, when the individual parameters were set at the respective appropriate values, significant improvements could be obtained by the synergistic effect, i.e., an effect more than the sum of improvements obtained by the individual parameters.

According to this embodiment, therefore, the selection of parameters as described above makes it possible to easily obtain a semiconductor laser device having excellent laser characteristics, such as the maximum operating temperature and the threshold current density, and capable of performing short-wavelength oscillation.

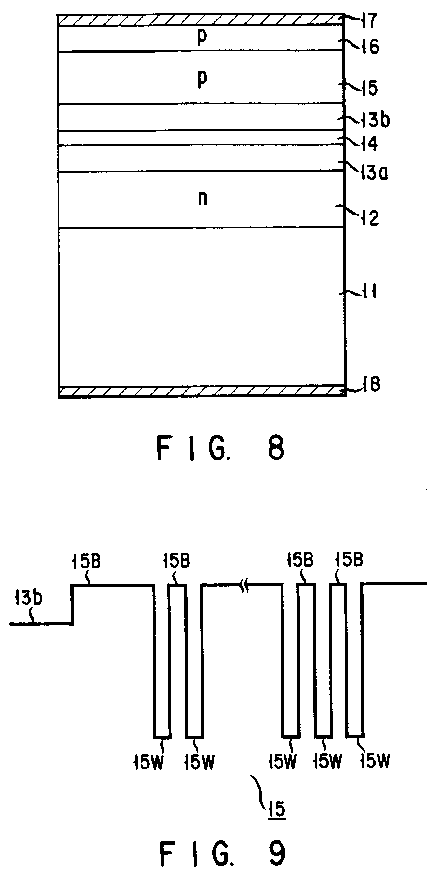

Fig. 8 is a sectional view showing the main part of an MQB semiconductor laser device according to another embodiment of the present invention.

An n-type cladding layer 12 consisting of ZnSₓSe₁₋ₓ, for example, ZnS_{0.1}Se_{0.9} and having a thickness of about 0.8 µm is formed on a GaAs substrate 11. An active layer 14 consisting of Zn_{0.8}Cd_{0.2}S_{0.05}Se_{0.95} and sandwiched between optical guide layers 13a and 13b consisting of nondoped ZnS_{0.05}Se_{0.95} is formed on the n-type cladding layer 12.

A p-type cladding layer 15 having an MQB structure consisting of ZnSₓSe₁₋ₓ, for example, ZnS_{0.1}Se_{0.9} and having a thickness of about 0.8 µm is formed on the optical guide layer 13b. This p-type cladding layer 15, together with the n-type cladding layer 12, the guide layers 13a and 13b, and the active layer 14, constitutes a DH junction portion.

An Au/Zn p-type electrode 17 is formed on the p-type cladding layer 15 via a p-type contact layer 16 consisting of p-type GaAs. An Au/Ge n-type electrode 18 is formed on the other side of the substrate 11.

Fig. 9 shows the potential distribution of the MQB structure constituted by the active layer 14 and the p-type cladding layer 15. As is apparent from Fig. 9, the p-type cladding layer 15 is modulated in regard to energy. That is, quantum wells 15W and quantum barriers 15B are formed.

In this embodiment, to improve the laser characteristics, various parameters were optimized in consideration of the same respects as in the previous embodiment. As a result, it was found that the same concepts as in the previous embodiment could be applied to the parameters.

That is, as the quantum well width decreased, the interference effect between wells basically increased, and overflow of carriers became hard to occur. When the quantum well width increased, on the other hand, almost no interference effect could be obtained. This study on the quantum well width revealed that the characteristics were able to be improved if the quantum well width was 1 to 8 nm.

Since the transmission coefficient of the wave function of electrons increases if the quantum barrier width decreases, the quantum barrier cannot function as a barrier any longer. If the quantum barrier width increases, on the other hand, the interference effect between the wells decreases, and this makes it impossible to obtain a satisfactorily large effective barrier height. It was also found that neighboring quantum barriers affected each other. From this study on the quantum well width, it was found that a good result was obtained when the width of the first quantum barrier in the p-type cladding layer 15 from the active layer 14 side was 24 to 100 nm, the width of the second quantum barrier was 1 to 20 nm, and the widths of the third and subsequent quantum barriers were 1 to 8 nm.

The number of quantum barriers has an effect on the effective barrier height. That is, it was found that an increase in number of quantum barriers enhanced the interference effect between the quantum wells. As a result, the effective barrier height increased, and overflow of carriers became hard to occur. However, the effective barrier height saturated when the number of quantum barriers exceeded a value. The present inventors made extensive studies on the number of quantum barriers having this tendency and found that an appropriate number was 3 to 10. Note that as the Group II-VI semiconductor material for the quantum barriers, it is possible to use, for example, ZnₓMg₁₋ₓS_{y}Se_{1-y} in place of ZnSₓSe₁₋ₓ (ZnS_{0.1}Se_{0.9}) used in this embodiment.

As the Group II-VI semiconductor material for the quantum wells, it is possible to use, for example, ZnSeₓTe₁₋ₓ, ZnₓCd₁₋ₓSe, ZnSₓTe₁₋ₓ, Zn₁₋ₓCdₓS, and their mixed crystal Zn₁₋ₓCdₓSe_{1-y-z}Te_{z} in place of ZnSₓSe₁₋ₓ (ZnS_{0.1}Se_{0.9}) used in this embodiment. Of the Group II elements, Zn, Cd, and Mg are particularly preferable. Of the Group VI elements, S, Se, and Te are particularly preferable. A high MQB effect can be expected by combining these Group II elements and Group VI elements.

In stead of the above materials, a material consisting of Group III-V elements, such as In₁₋ₓGaₓAs_{1-y}Py, Ga₁₋ₓAℓₓAs, or In_{y}(Ga₁₋ₓAℓₓ)_{1-y}P can be used. This is so because when the material consisting of Group II-VI elements is used, it is more or less difficult to increase the band gap difference between the quantum well and the quantum barrier by controlling the quantum well composition ratio and the quantum barrier composition ratio.

As described above, when the individual parameters were set at the respective appropriate values, remarkable improvements could be obtained by the synergistic effect, i.e., an effect more than the sum of improvements obtained by the individual parameters.

According to this embodiment, therefore, the selection of the parameters as described above makes it possible to easily obtain a semiconductor laser device having excellent laser characteristics, such as a maximum operating temperature and a low threshold current density, and capable of performing short-wavelength oscillation.

According to the present invention as has been described in detail above, it is possible to obtain a practical semiconductor laser device having improved laser characteristics, such as the threshold current density and the maximum operating temperature, and capable of performing short-wavelength oscillation.

## Claims

1. A semiconductor laser device comprising:
a substrate (1);
a first cladding layer (2) formed on said substrate (1);
an active layer (4) formed on said first cladding layer;
and
a second cladding layer (5) formed on said active layer (4) having a conductivity type different from that of said first cladding layer (2);
wherein at least one of said first and second cladding layers (2, 5) has a. multiquantum barrier structure including a plurality of barrier layers and a plurality of well layers, each barrier layer and each well layer being alternately stacked, the width of a first barrier layer relative to a side of said active layer being 24 to 100 nm and the width of a second barrier layer relative to a side of said active layer being 5 to 20 nm.

2. A device according to claim 1, wherein widths of third and subsequent barrier layers counted relative to a side of said active layer are 1 to 8 nm.

3. A device according to claim 1, wherein a width of each well layer of said multiquantum barrier structure is 1 to 8 nm.

4. A semiconductor laser device comprising:
a substrate (1);
a first cladding layer (2) formed on said substrate (1);
an active layer (4) formed on said first cladding layer (2);
and
a second cladding layer (5) formed on said active layer (4) having a conductivity type different from said first cladding layer (2),
wherein at least one of said first and second cladding layers (2, 5) has a multiquantum barrier structure, and said multiquantum barrier structure is constituted by alternately stacking a plurality of barrier layers each consisting essentially of In_{z}(Ga₁₋ₓAℓₓ)_{1-z} P, x is 0.7 to 1.0 and z is 0 to 1.0, and a plurality of well layers each consisting essentially of In_{z}(Ga_{1-y}Aℓ_{y})_{1-z}P, y is 0 to 0.3 and z is 0 to 1.0, the width of a first barrier layer relative to a side of said active layer being 24 to 100 nm, the width of a second barrier layer relative to a side of said active layer being 5 to 20 nm.

5. A device according to claim 4, wherein widths of third and subsequent barrier layers counted from the side of said active layer are 1 to 8 nm.

6. A device according to claim 4, wherein a width of each well of said multiquantum barrier structure is 1 to 8 nm.

## Patentansprüche

1. Halbleiterlaservorrichtung mit:
einem Substrat (1),
einer ersten Überzugschicht (2), die auf dem Substrat (1) gebildet ist,
einer aktiven Schicht (4), die auf der ersten Überzugschicht gebildet ist, und
einer zweiten Überzugschicht (5), die auf der aktiven Schicht (4) gebildet ist, mit einem Leitfähigkeitstyp, der von demjenigen der ersten Überzugschicht (2) verschieden ist,
wobei wenigstens eine Schicht aus den ersten und zweiten Überzugschichten (2, 5) eine Mehrquantenbarrierestruktur einschließlich einer Vielzahl von Barriereschichten und einer Vielzahl von Wannenschichten hat, jede Barriereschicht und jede Wannenschicht abwechselnd gestapelt sind, die Breite der ersten Barriereschicht bezüglich zu einer Seite der aktiven Schicht 24 bis 100 nm beträgt und die Breite der zweiten Barriereschicht bezüglich einer Seite der aktiven Schicht 5 bis 20 nm beträgt.

2. Vorrichtung nach Anspruch 1, bei der die Breiten der dritten und folgenden Barriereschichten, gezählt bezüglich einer Seite der aktiven Schicht, 1 bis 8 nm betragen.

3. Vorrichtung nach Anspruch 1, bei der eine Breite von jeder Wannenschicht der Mehrquantenbarrierestruktur 1 bis 8 nm beträgt.

4. Halbleiterlaservorrichtung mit:
einem Substrat (1),
einer ersten Überzugschicht (2), die auf dem Substrat (1) gebildet ist,
einer aktiven Schicht (4), die auf der ersten Überzugschicht gebildet ist, und
einer zweiten Überzugschicht (5), die auf der aktiven Schicht (4) gebildet ist, mit einem Leitfähigkeitstyp, der von demjenigen der ersten Überzugschicht (2) verschieden ist,
wobei wenigstens eine Schicht aus der ersten und zweiten Überzugschicht (2, 5) eine Mehrquantenbarrierestruktur hat und die Mehrquantenbarrierestruktur durch abwechselndes Stapeln einer Vielzahl von Barriereschichten, die jeweils im wesentlichen aus In_{z}(Ga₁₋ₓAlₓ)_{1-z}P, mit x ist 0,7 bis 1,0 und z ist 0 bis 1,0 bestehen, und einer Vielzahl von Wannenschichten, die jeweils im wesentlichen aus In_{z}(Ga_{1-y}Al_{y})_{1-z}P mit y ist 0 bis 0,3 und z ist 0 bis 1,0 bestehen, gebildet ist, wobei die Breite einer ersten Barriereschicht relativ zu einer Seite der aktiven Schicht 24 bis 100 nm und die Breite der zweiten Barriereschicht relativ zu einer Seite der aktiven Schicht 5 bis 20 nm betragen.

5. Vorrichtung nach Anspruch 4, bei der Breiten der dritten und folgenden Barriereschichten, gezählt von der Seite der aktiven Schicht, 1 bis 8 nm sind.

6. Vorrichtung nach Anspruch 4, bei der eine Breite von jeder Wanne der Mehrquantenbarrierestruktur 1 bis 8 nm ist.

## Revendications

1. Dispositif laser à semiconducteur comportant:
un substrat (1);
une première couche de placage (2) formée sur ledit substrat (1);
une couche active (4) formée sur ladite première couche de placage;
et
une seconde couche de placage (5) formée sur ladite couche active (4) et d'un type de conductivité différent de celui de ladite première couche de placage (2);
dans le cas duquel au moins l'une desdites première et seconde couches de placage (2, 5) a une structure de couche d'arrêt multiquantique incluant une pluralité de couches d'arrêt et une pluralité de couches formant caisson d'isolement, chaque couche d'arrêt et chaque couche formant caisson d'isolement étant alternativement empilées, la largeur d'une première couche d'arrêt depuis une face de ladite couche active étant 24 à 100 nm et la largeur d'une seconde couche d'arrêt depuis une face de ladite couche active étant 50 à 20 nm.

2. Dispositif selon la revendication 1, dans lequel les largeurs de la troisième couche d'arrêt et des couches suivantes comptée depuis une face de ladite couche active sont 1 à 8 nm.

3. Dispositif selon la revendication 1, dans lequel une largeur de chaque couche formant caisson isolant de ladite structure de couches d'arrêt multiquantiques est 1 à 8 nm.

4. Dispositif laser à semiconducteur comportant:
un substrat (1);
une première couche de placage (2) formée sur ledit substrat (1);
une couche active (4) formée sur ladite première couche de placage;
et
une seconde couche de placage (5) formée sur ladite couche active (4) et d'un type de conductivité différent de celui de ladite première couche de placage (2);
dans lequel au moins l'une desdites première et seconde couches de placage (2, 5) a une structure de couche d'arrêt multiquantique et ladite structure de couche d'arrêt multiquantique est constituée par empilage alternatif d'une pluralité de couches d'arrêt, chacune constituée essentiellement de In_{z}(Ga₁₋ₓAℓₓ)_{1-z}P, x est 0,7 à 1,0 et z est 0 à 1,0 et d'une pluralité de couches formant caisson d'isolement, chacune essentiellement constituée de In_{z}(Ga_{1-y}Aℓ_{y})_{1-z}P, y est 0 à 0,3 et z est 0 à 1,0, la largeur d'une première couche d'arrêt à partir d'une face de ladite couche active étant 24 à 100 nm, la largeur d'une seconde couche d'arrêt à partir d'une face de ladite couche active étant 5 à 20 nm.

5. Dispositif selon la revendication 4, dans lequel les largeurs de la troisième couche d'arrêt et des couches suivantes contenue depuis une face de ladite couche active sont 1 à 8 nm.

6. Dispositif selon la revendication 4, dans lequel une largeur de chaque couche formant caisson isolant de ladite structure de couches d'arrêt multiquantiques est 1 à 8 nm.
